# DEMANDE DE BREVET EUROPEEN

(11) **EP 4 704 513 A1**
(43) Date de publication de la demande: **04.03.2026**
(21) Numéro de dépôt: 25196757.6
(22) Date de dépôt: 19.08.2025
(51) Int. Cl.: H10D 1/00, H10D 1/20, H10D 80/20, H10D 1/47, H10D 1/68

(54) **DISPOSITIF ELECTRONIQUE PASSIF**

(30) Priorité: 27.08.2024 FR 2409148
(71) Demandeur: STMicroelectronics International N.V., 1228 Plan-les-Ouates, Geneva (CH)
(72) Inventeur: BOUTALEB, Mohamed, 37100 Tours (FR)
(74) Mandataire: Cabinet Beaumont

(57) **Abrégé**

La présente description concerne un dispositif électronique (201) passif intégré comportant un empilement dans l'ordre, à partir d'une face supérieure d'un support, d'une couche isolante (113), d'une couche métallique (107) et d'une couche de passivation (109) en un matériau isolant électriquement, la couche de passivation (109) recouvrant la face supérieure et des flancs latéraux de la couche métallique (107),
dans lequel une couche tampon (117), en un autre matériau isolant électriquement, différent du matériau de la couche de passivation (109), est formée sur des arêtes supérieures de la couche métallique (107) entre la couche métallique (107) et la couche de passivation (109), la couche tampon (117) étant en contact avec la couche métallique (107).

## Description

### Domaine technique

La présente description concerne de façon générale les dispositifs électroniques passifs et plus particulièrement les dispositifs électroniques passifs intégrés.

### Technique antérieure

Les dispositifs électroniques passifs intégrés correspondent à des composants électroniques passifs, de type résistance, inductance ou capacité intégrés seuls ou à plusieurs dans un même boitier ou sur un même substrat ou support.

Il serait souhaitable d'améliorer au moins en partie certains aspects de tels dispositifs.

### Résumé de l'invention

Pour cela, un mode de réalisation prévoit un dispositif électronique passif intégré comportant un empilement dans l'ordre, à partir d'une face supérieure d'un support, d'une couche isolante, d'une couche métallique et d'une couche de passivation en un matériau isolant électriquement, la couche de passivation recouvrant la face supérieure et des flancs latéraux de la couche métallique, dans lequel une couche tampon, en un autre matériau isolant électriquement, différent du matériau de la couche de passivation, est formée sur des arêtes supérieures de la couche métallique entre la couche métallique et la couche de passivation, la couche tampon étant en contact avec la couche métallique.

Selon un mode de réalisation, la couche métallique est en cuivre.

Selon un mode de réalisation, la couche de passivation est en un matériau polymère.

Selon un mode de réalisation, la couche de passivation est en polybenzoxazole, en benzocyclobutène et/ou en un polyimide.

Selon un mode de réalisation, la couche tampon est en nitrure de silicium, en alumine, en oxide d'aluminium ou en nitrure d'aluminium.

Selon un mode de réalisation, la couche tampon s'étend à partir des arêtes de la couche métallique sur la face supérieure et les flancs latéraux de la couche métallique sur une largeur supérieure à 1,5 µm.

Selon un mode de réalisation, la couche tampon recouvre une partie inférieure des flancs latéraux de la couche métallique.

Selon un mode de réalisation, le dispositif comporte, entre la couche isolante et la couche métallique, d'autres couches isolante et métallique.

Selon un mode de réalisation, la couche tampon est en un matériau ayant une limite à la rupture supérieure à celle du matériau de la couche de passivation.

Selon un mode de réalisation, les flancs latéraux de la couche métallique comportent une portion non recouverte par la couche tampon.

Un autre mode de réalisation prévoit un procédé de fabrication d'un dispositif électronique passif intégré comportant les étapes successives suivantes :
- dépôt d'une couche tampon, sur un empilement comportant dans l'ordre, à partir d'une face supérieure d'un support, une couche isolante et une couche métallique ;
- dépôt d'un couche de passivation en un matériau isolant électriquement, la couche de passivation recouvrant la couche tampon et la face supérieure et des flancs latéraux de la couche métallique,
la couche tampon étant en contact avec la couche métallique et étant en un autre matériau isolant électriquement, différent du matériau de la couche de passivation.

Selon un mode de réalisation, le procédé comprend en outre une étape de gravure isotrope de la couche tampon de façon à retirer une partie de la couche tampon formée sur les flancs latéraux de la couche métallique.

Selon un mode de réalisation, le dépôt de la couche tampon est réalisé par une méthode de dépôt conforme.

Selon un mode de réalisation, une partie de la couche tampon située à l'aplomb d'une partie centrale de la couche métallique est retirée.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A est une vue en coupe, partielle et schématique, illustrant un exemple d'un dispositif électronique passif ;
la figure 1B est un graphique illustrant la répartition de contraintes mécaniques au sein du dispositif électronique passif illustré en figure 1A ;
la figure 2 est une vue en coupe, partielle et schématique, illustrant un exemple d'un dispositif électronique passif selon un premier mode de réalisation ;
la figure 3 est une vue en coupe, partielle et schématique, illustrant un exemple d'un dispositif électronique passif selon un deuxième mode de réalisation ; et
la figure 4 est une vue en coupe, partielle et schématique, illustrant un exemple d'un dispositif électronique passif selon un troisième mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, une partie seulement d'un dispositif passif, correspondant à un composant passif, a été décrit ici, le dispositif peut comprendre d'autres composants dont les structures et les connexions n'ont pas été décrites.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

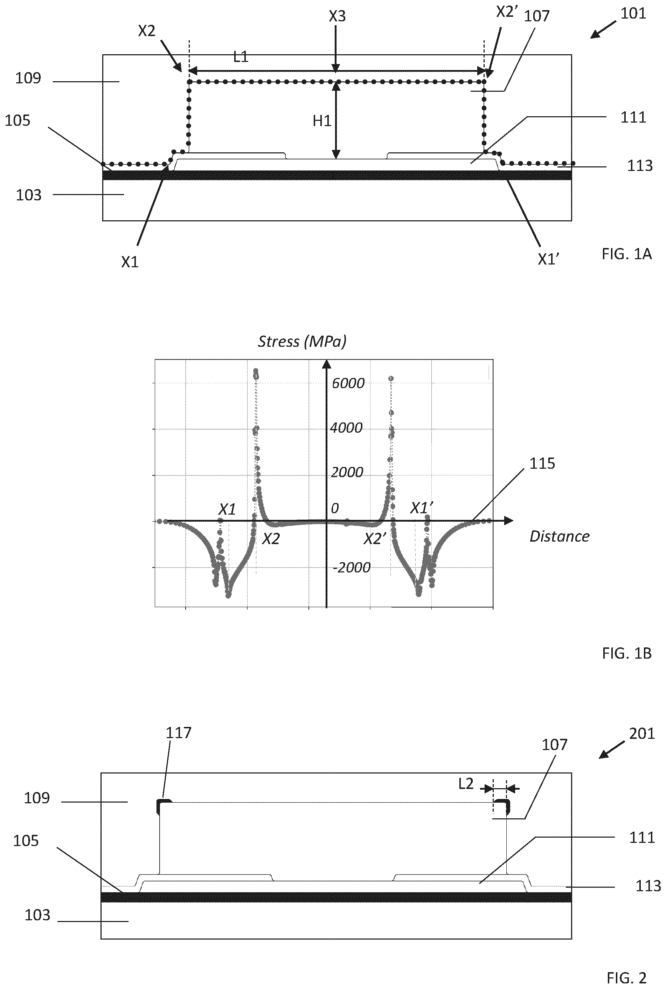

La figure 1A est une vue en coupe, partielle et schématique, illustrant un exemple d'un dispositif électronique passif 101.

Le dispositif 101 comporte un support 103 sur lequel est formé un empilement comportant, dans l'ordre, à partir d'une face supérieure du support 103, une couche isolante 105, une couche métallique 107 et une couche de passivation 109.

A titre d'exemple, le dispositif 101 comporte en outre, entre la couche isolante 105 et la couche métallique 107, une autre couche métallique 111 surmontée d'une autre couche isolante 113.

A titre d'exemple, le support 103 est en un matériau semiconducteur, par exemple en silicium, par exemple en silicium de haute résistivité, ou en un matériau non semiconducteur, par exemple en verre. A titre d'exemple, le substrat de support 103 est en un matériau présentant une résistivité électrique supérieure à 2,5 KΩ.cm.

La couche isolante 105 est par exemple en contact, par sa face inférieure, avec la face supérieure du support 103. A titre d'exemple, la couche isolante 105 recouvre l'entièreté de la face supérieure du support 103. A titre d'exemple, la couche isolante 105 est une couche en un matériau diélectrique, par exemple en un oxyde, par exemple en un verre de silicium non dopé (USG, de l'anglais "Undoped Silicon Glass"). A titre d'exemple, la couche isolante 105 a une épaisseur comprise entre 0,5 µm et 5 µm, par exemple de l'ordre de 1,2 µm.

A titre d'exemple, la couche métallique 111 est formée sur, et par exemple en contact par sa face inférieure avec, la face supérieure de la couche isolante 105. La couche métallique 111 s'étend, par exemple sur une partie seulement de la surface de la couche isolante 105. A titre d'exemple, la couche métallique 111 est en aluminium. A titre d'exemple, la couche métallique 111 a une épaisseur comprise entre 0,5 µm et 5 µm, par exemple de l'ordre de 1,5 µm.

A titre d'exemple, la couche isolante 113 recouvre la couche métallique 111 et une portion de la couche isolante 105 non recouverte par la couche métallique 111, autour de la couche métallique 111. A titre d'exemple, la couche isolante 113 est en contact, par sa face inférieure, avec la face supérieure de la couche métallique 111 et une portion de la face supérieure de la couche isolante 105. A titre d'exemple, la couche isolante 113 recouvre l'entièreté de la couche métallique 111 à l'exception d'une partie centrale de la couche métallique 111 qui n'est pas recouverte par la couche isolante 113. A titre d'exemple, la couche isolante 113 recouvre en outre les flancs latéraux de la couche métallique 111. La couche isolante 113 est par exemple en un matériau diélectrique, par exemple en un oxyde, par exemple en un verre de silicium non dopé (USG, de l'anglais "Undoped Silicon Glass"). A titre d'exemple, la couche isolante 113 a une épaisseur comprise entre 0,1 µm et 2 µm, par exemple de l'ordre de 0,8 µm.

La couche métallique 107 recouvre la couche isolante 105. A titre d'exemple, la couche métallique 107 recouvre une partie seulement de la couche isolante 105. Dans l'exemple de la figure 1A, la couche métallique 107 recouvre en outre la couche isolante 113 et la partie de la couche métallique 111 non recouverte par la couche isolante 113. A titre d'exemple, la couche métallique 107 est formée à l'aplomb de la couche métallique 111 et a, en vue de dessus, une surface inférieure à la surface de la couche métallique 111. A titre d'exemple, la face inférieure de la couche métallique 107 est en contact avec une partie de la face supérieure de la couche isolante 113 et la partie de la face supérieure de la couche métallique 111 non recouverte par la couche isolante 113. A titre d'exemple, la couche métallique 107 a une largeur L1 comprise entre 10 µm et 275 µm, par exemple de l'ordre de 263 µm. La couche métallique 107 est par exemple en cuivre. La couche métallique 107 s'étend, par exemple, sur une hauteur H1 comprise entre 3 µm et 15 µm, par exemple de l'ordre de 10 µm.

La couche de passivation 109 recouvre par exemple la structure formée par les couches 105, 111, 113 et 107. Plus précisément, la couche de passivation 109 recouvre la face supérieure et les flancs latéraux de la couche métallique 107. La couche de passivation 109 recouvre en outre la portion de face supérieure de la couche isolante 113 non recouverte par la couche métallique 107. A titre d'exemple, la couche de passivation 109 a une face supérieure plane. La couche de passivation 109 est par exemple en un matériau isolant électriquement. La couche de passivation 109 est par exemple en un matériau polymère, par exemple en polybenzoxazole (PBO), en benzocyclobutène (BCB) et/ou en un polyimide (PI). A titre d'exemple, la couche de passivation 109 s'étend au dessus de la couche métallique 107 sur une épaisseur comprise entre 2 µm et 6 µm, par exemple comprise entre 3 µm et 4 µm.

A titre d'exemple, le dispositif 101 correspond à un dispositif passif intégré (IPD, de l'anglais "Integrated Passive Device") comportant une résistance, une inductance et une capacité.

A titre d'exemple, les couches métalliques 107 et 111 ont, en vue de dessus, une forme de spirale s'étendant à la surface du support 103. L'ensemble formé par les couches 105, 111, 113 et 107 correspond alors à une bobine ou inductance du dispositif IPD 101. En variante, les couches métalliques 107 et 111 ont, en vue de dessus, une forme ronde, carré, rectangulaire, ou toute autre forme. A titre de variante, le dispositif 101 correspond à un composant passif autre qu'une inductance, par exemple une résistance ou une capacité.

Le support 103 porte par exemple un ou plusieurs autres composants, non représentés, tels que des ccapacités ou des résistances formées à proximité de l'inductance et connectés électriquement à l'inductance.

Dans un tel dispositif, les inventeurs ont constaté que, lors de cyclages thermiques, dans le cadre de tests de fiabilité en température des dispositifs 101, la couche de passivation 109 présente des fissures s'étendant, dans l'épaisseur de la couche de passivation 109, à partir des arêtes supérieures de la couche métallique 107. De telles fissures peuvent traverser l'épaisseur de la couche de passivation 109 pour atteindre, par exemple la face supérieure de la couche de passivation 109. Par arêtes supérieures de la couche métallique 107, on entend les jonctions entre la face supérieure de la couche métallique 107 et chacun des flancs latéraux de la couche métallique 107.

De telles fissures peuvent provoquer une délamination de la couche métallique 107 ou de la couche de passivation 109 et impacter la fiabilité et la durée de vie des composants.

La figure 1B est un graphique illustrant la répartition de la contrainte mécanique subie au sein du dispositif électronique passif illustré en figure 1A lors de cyclages thermiques.

Le graphique de la figure 1B illustre, par une courbe 115, la contrainte mécanique (Stress) reçue et accumulée, le long de la face inférieure de la couche de passivation 109, représenté par un trait en pointillé sur la figure 1A. Plus précisément, dans le graphique de la figure 1B, la courbe 115 représente l'évolution de la contrainte (Stress), en ordonnée, en mégapascal(MPa), en fonction de la position (Distance), en micromètres, le long de la face inférieure de la couche de passivation 109, dont l'origine est située, en X3, en vis-à-vis du centre de la couche métallique 107.

L'évolution de la contrainte le long de la face inférieure de la couche de passivation 109 montre que la contrainte est négative et minimale, en X1 et X1', de part et d'autre de la couche métallique 107, à l'aplomb de la couche 113, lorsque celle-ci est en contact avec la couche 105. Cette valeur de contrainte négative signifie que la contrainte reçue est une contrainte de compression.

Le long de la face inférieure de la couche de passivation 109, en direction du centre de la couche métallique 107, la contrainte augmente ensuite pour atteindre une contrainte positive et maximale, en X2 et X2' sur les arêtes de la couche métallique 107. Cette valeur de contrainte positive signifie que la contrainte reçue est une contrainte de traction.

Le long de la partie centrale de la couche métallique 107, le stress rediminue, à partir des arêtes de la couche métallique 107, pour atteindre une valeur constante, ici nulle, en X3 au centre de la couche métallique 107. Cette valeur de contrainte nulle signifie que, à ces endroits de la face inférieure de la couche de passivation 109, la couche ne subit ni de contrainte de traction ni de contrainte de compression.

La variation de la contrainte s'explique par le fait que le dispositif électronique 101 est formé par une succession de plusieurs couches de natures et matériaux différents. Ces couches ont notamment des comportements thermo-méchaniques différents et ont plus particulièrement des coefficients de dilatation thermique (CTE, ce l'anglais Coefficient of Thermal Expansion") différents.

Lors de cyclages thermiques, les dilatations thermiques des différentes couches se cumulent en générant sur la face inferieure de la couche de passivation 109, une contrainte. Lorsque la contrainte reçue localement est supérieure à la limite de rupture (également appelée résistance ultime à la traction et exprimée en MPa ou N/mm²), la couche de passivation 109 se fissure en créant, à partir du point de rupture, les fissures mentionnées en relation avec la figure 1A.

La figure 2 est une vue en coupe, partielle et schématique, illustrant un exemple d'un dispositif électronique passif 201 selon un premier mode de réalisation. Le dispositif de la figure 2 comprend les mêmes éléments que le dispositif de la figure 1A, agencés sensiblement de la même manière, et diffère du dispositif de la figure 1A en ce qu'il comporte en outre une couche tampon 117 ("stress buffer layer" ou SBL en anglais) entre la couche métallique 107 et la couche de passivation 109.

Dans le mode de réalisation illustré en figure 2, la couche tampon 117 est formée sur les arêtes supérieures de la couche métallique 107.

La couche tampon 117 est en un matériau ayant par exemple une limite à la rupture supérieure à celle du matériau de la couche de passivation 109. La couche tampon 117 est une couche en un matériau différent du matériau de la couche de passivation 109. A titre d'exemple, la couche tampon 117 est en un matériau isolant, par exemple un matériau diélectrique. La couche tampon 117 est par exemple en nitrure de silicium, en alumine, en oxide d'aluminium ou en nitrure d'aluminium.

A titre d'exemple, la couche tampon 117 est formée sur les arêtes de la couche métallique 107 et s'étend, à partir des arêtes, sur les faces latérales et supérieure de la couche métallique 107 sur une largeur L2 supérieure à 1 µm, par exemple supérieure à 1,5 µm. La couche tampon 117 est en contact, par sa face inférieure, avec la face supérieure de la couche métallique 107. A titre d'exemple, la couche tampon 117 est en outre en contact, par sa face supérieure, avec la face inférieure de la couche de passivation 109.

A titre d'exemple, la couche tampon 117 est formée à l'issue de la formation de la couche métallique 107 sur l'empilement formé par les couches 105, 111 et 113 sur la face supérieure du support 103. A titre d'exemple, la couche tampon 117 est formée avant la formation de la couche de passivation 109. La couche tampon 117 est par exemple formée pleine plaque, c'est-à-dire sur l'ensemble de la face supérieure de l'empilement susmentionné. A titre d'exemple, la couche tampon 117 est déposée par un procédé de dépôt par évaporation. En variante, la couche tampon 117 est déposée par un procédé de dépôt par pulvérisation. Encore en variante, la couche tampon 117 est déposée par une méthode de dépôt de couches atomique (ALD, de l'anglais "Atomic Layer Deposition"). La couche tampon 117 est par exemple formée de façon conforme avec une épaisseur comprise entre 0,2 µm et 5 µm, par exemple de l'ordre de 1 µm.

A titre d'exemple, la couche tampon 117 est, à la suite de son dépôt, retirée localement de façon à n'être conservée que sur et au voisinage de arêtes de la couche métallique 107. A titre d'exemple, le retrait local de la couche tampon 117 est réalisé par une gravure de type isotrope de façon à pouvoir retirer des portions de la couche tampon 117 sur les flancs latéraux et supérieur de la couche métallique 107.

A titre d'exemple, le retrait local de la couche tampon 117 est effectué par une gravure humide. En variante, le retrait local de la couche tampon 117 est effectué par une gravure physique, par exemple par plasma non polarisé.

A titre d'exemple, à l'issue de la formation de la couche tampon 117, la couche métallique 107 a une partie inférieure de ses flancs latéraux exposés et non recouverts par la couche tampon 117. A titre d'exemple, à l'issue de la formation de la couche tampon 117, la couche métallique 107 a une partie centrale de sa face supérieure libre et non recouverte par la couche tampon 117.

A titre d'exemple, bien que cela ne soit pas représenté en figure 2, à l'issue de la formation de la couche de passivation 109, celle-ci peut être gravée de façon à y former une ouverture traversante débouchant sur la face supérieure de la couche métallique 107 permettant, à l'aide d'une couche conductrice de former une reprise de contact de la couche métallique 107.

Un avantage du présent mode de réalisation est qu'il permet d'absorber la dilatation thermique à l'interface entre les couches 107 et 109et limiter la contrainte reçue par la face inférieure de la couche de passivation 109 à l'aplomb de la couche tampon 117.

Un autre avantage du présent mode de réalisation est que la contrainte reçue par la face inférieure de la couche de passivation 109 est inférieure à la limite à la rupture, réduisant ainsi les risque de formation de fissures dans la couche de passivation 109.

Encore un autre avantage du présent mode de réalisation est que la couche tampon 117 permet la redistribution, de la contrainte accumulée au niveau des arêtes de la couche métallique 107, sur l'ensemble de la face supérieure de la couche métallique 107.

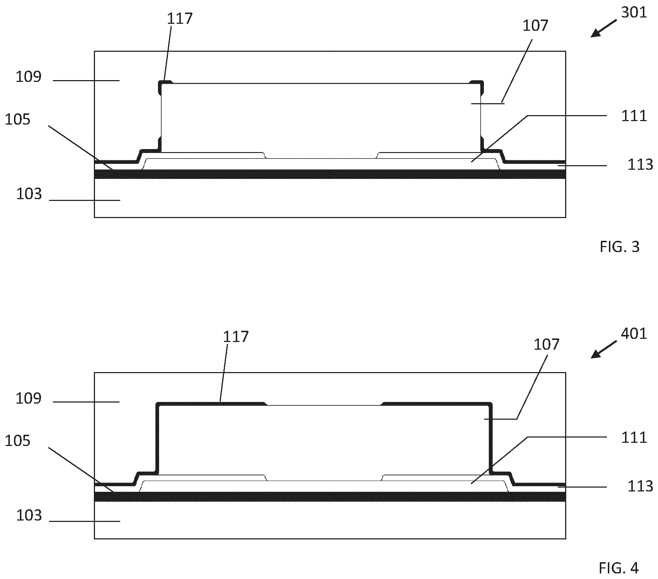

La figure 3 est une vue en coupe, partielle et schématique, illustrant un exemple d'un dispositif électronique passif 301 selon un deuxième mode de réalisation.

Plus particulièrement, la figure 3 illustre un dispositif 301 similaire au dispositif 201 illustré en figure 2 à la différence près que, dans le dispositif 301 illustré en figure 3, la couche tampon 117 s'étend sur une partie inférieure des flancs latéraux de la couche métallique 107 et sur la face supérieure de la couche en oxyde 113, autour de la couche métallique.

La figure 4 est une vue en coupe, partielle et schématique, illustrant un exemple d'un dispositif électronique passif 401 selon un troisième mode de réalisation.

Plus particulièrement, la figure 4 illustre un dispositif 401 similaire au dispositif 201 illustré en figure 2 à la différence près que, dans le dispositif illustré en figure 4, la couche tampon 117 s'étend sur l'entièreté des flancs latéraux de la couche métallique 107. Dans ce mode de réalisation, la couche tampon 117 s'étend de plus sur la face supérieure de la couche en oxyde 113, autour de la couche métallique 107. En outre, dans ce mode de réalisation, la couche tampon 117 s'étend sur la face supérieure de la couche métallique 107 sur une surface plus importante que ce qui a été décrit dans le mode de réalisation illustré en relation avec la figure 2. Dans ce mode de réalisation, la couche tampon 117 s'étend sur l'entièreté de la surface de la face supérieure de la couche métallique à l'exception d'une portion centrale d'une largeur comprise entre 10 µm et 75 µm, par exemple de l'ordre de 30 µm, permettant la reprise de contact de la couche métallique 107.

Dans ce mode de réalisation, contrairement à ce qui a été décrit en relation avec la figure 2, la gravure de la couche tampon peut être une gravure anisotrope. En effet, les portions de couche tampon 117 présentes sur les flancs latéraux de la couche métallique 107 sont, dans ce mode de réalisation, conservées.

Un avantage du troisième mode de réalisation est qu'il permet de laisser subsister la couche tampon 117 sur les flancs de la couche métallique 107 et ainsi simplifier la ou les étapes de gravure de la couche tampon 117 à la suite de son dépôt.

De nombreuses applications sont susceptibles de tirer profit des avantages procurés par le dispositif électronique 201, ce dispositif 201 pouvant ainsi être intégré dans divers types de composants.

À titre d'exemple, le dispositif 201 peut être intégré dans un composant destiné à l'industrie automobile. L'électrification des véhicules automobiles cause une forte augmentation du nombre de composants électroniques présents dans les véhicules. À titre d'exemple, le dispositif 201 peut être intégré dans un composant destiné à l'industrie. En particulier, le composant est par exemple utilisé pour le développement des énergies vertes ou pour l'électrification d'infrastructures, par exemple pour des bornes de recharge ou pour la collecte d'énergie solaire. Le composant peut également être utilisé dans le domaine de l'internet des objets ou dans le domaine des maisons connectées. Le composant est par exemple destiné à être mis en œuvre dans des circuits d'alimentation en énergie électrique d'équipements. Le composant peut également être utilisé pour la mise en œuvre de systèmes d'informatique dans le nuage, de réseaux de communication radiofréquence 5G, de centres de données et de serveurs.

À titre d'exemple, le dispositif 201 peut être intégré dans un composant destiné à être utilisé dans l'électronique personnelle, par exemple mettant en oeuvre des communication radiofréquence, dans des systèmes de communication 5G, ou plus généralement dans tout composant connecté. Le composant est par exemple un téléphone mobile, ou smartphone, ou fait partie d'un réseau de l'internet des objets. Le composant est par exemple connecté par 5G, par WiFi ou par communication large bande. Le composant comprend par exemple des interfaces à haut débit, par exemple avec un filtrage avancé et une protection contre les décharges électrostatiques.

À titre d'exemple, le dispositif 201 peut être intégré dans un composant destiné à être utilisé dans des équipements de communication, ou dans des ordinateurs et des périphériques. Le composant est par exemple utilisé dans des infrastructures 5G et des centres de données dédiés. Le composant peut également être utilisé dans des satellites comprenant par exemple des composants passifs intégrés pour des applications radiofréquence.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que l'empilement formé par les couches 103, 105, 107 et 109 correspond ici à l'empilement d'une capacité (ou condensateur), on peut prévoir qu'une couche tampon 117 telle que décrit dans les modes de réalisation des figures 2 à 4 peut être formée dans d'autres types de composants passifs comme des inductances (ou bobines) ou des résistances. En outre, une telle couche tampon peut être formée plus généralement à l'interface entre une couche métallique, par exemple en cuivre, et une couche de passivation, par exemple en un matériau polymère, par exemple en PBO, BCB ou polyimide, dans le but de réduire la contrainte formée sur les arêtes de la couche en cuivre.

Enfin, la mise en oeuvre pratique des modes de réalisation et variantes décrits est à la portée de la personne du métier à partir des indications fonctionnelles données ci-dessus.

## Revendications

1. Dispositif électronique (201 ; 301 ; 401) passif intégré comportant un empilement dans l'ordre, à partir d'une face supérieure d'un support, d'une couche isolante (113), d'une couche métallique (107) et d'une couche de passivation (109) en un matériau isolant électriquement, la couche de passivation (109) recouvrant la face supérieure et des flancs latéraux de la couche métallique (107),
dans lequel une couche tampon (117), en un autre matériau isolant électriquement, différent du matériau de la couche de passivation (109), est formée sur des arêtes supérieures de la couche métallique (107) entre la couche métallique (107) et la couche de passivation (109), la couche tampon (117) étant en contact avec la couche métallique (107).

2. Dispositif selon la revendication 1, dans lequel la couche métallique (107) est en cuivre.

3. Dispositif selon la revendication 1 ou 2, dans lequel la couche de passivation (109) est en un matériau polymère.

4. Dispositif selon l'une quelconque des revendications 1 à 3, dans lequel la couche de passivation (109) est en polybenzoxazole, en benzocyclobutène et/ou en un polyimide.

5. Dispositif selon l'une quelconque des revendications 1 à 4, dans lequel la couche tampon (117) est en nitrure de silicium, en alumine, en oxide d'aluminium ou en nitrure d'aluminium.

6. Dispositif selon l'une quelconque des revendications 1 à 5, dans lequel la couche tampon (117) s'étend à partir des arêtes de la couche métallique (107) sur la face supérieure et les flancs latéraux de la couche métallique (107) sur une largeur (L2) supérieure à 1,5 µm.

7. Dispositif selon l'une quelconque des revendications 1 à 6, dans lequel la couche tampon (117) recouvre une partie inférieure des flancs latéraux de la couche métallique (107) .

8. Dispositif selon l'une quelconque des revendications 1 à 7, comportant, entre la couche isolante (105) et la couche métallique (109), d'autres couches isolante (113) et métallique (111).

9. Dispositif selon l'une quelconque des revendications 1 à 8, dans lequel la couche tampon (117) est en un matériau ayant une limite à la rupture supérieure à celle du matériau de la couche de passivation (109).

10. Dispositif selon l'une quelconque des revendications 1 à 9, dans lequel les flancs latéraux de la couche métallique (107) comportent une portion non recouverte par la couche tampon (117).

11. Procédé de fabrication d'un dispositif électronique (201 ; 301 ; 401) passif intégré comportant les étapes successives suivantes :
- dépôt d'une couche tampon (117), sur un empilement comportant dans l'ordre, à partir d'une face supérieure d'un support (103), une couche isolante (113) et une couche métallique (107) ;
- dépôt d'un couche de passivation (109) en un matériau isolant électriquement, la couche de passivation (109) recouvrant la couche tampon (117) et la face supérieure et des flancs latéraux de la couche métallique (107),
la couche tampon (117) étant en contact avec la couche métallique (107) et étant en un autre matériau isolant électriquement, différent du matériau de la couche de passivation (109).

12. Procédé selon la revendication 11, comprenant en outre une étape de gravure isotrope de la couche tampon (117) de façon à retirer une partie de la couche tampon (117) formée sur les flancs latéraux de la couche métallique (107).

13. Procédé selon la revendication 11 ou 12 dans lequel le dépôt de la couche tampon (117) est réalisé par une méthode de dépôt conforme.

14. Procédé selon l'une quelconque des revendications 11 à 13, dans lequel une partie de la couche tampon (117) située à l'aplomb d'une partie centrale de la couche métallique (107) est retirée.
